# EUROPEAN PATENT SPECIFICATION

(11) **EP 1 169 670 B1**
(45) Date of publication and mention of the grant of the patent: **10.05.2006**
(21) Application number: 00908547.3
(22) Date of filing: 08.02.2000
(51) Int. Cl.: G03F 7/20, H01L 21/00, H01L 33/00

(54) **PHOTOLITHOGRAPHY METHOD**
PHOTLITHOGRAPHIEVERFAHREN
PROCEDE DE PHOTOLITHOGRAPHIE

(30) Priority: 19.02.1999 JP 4159599
(43) Date of publication of application: 09.01.2002
(73) Proprietor: Agilent Technologies, Inc. (a Delaware corporation), Palo Alto, CA 94303 (US)
(72) Inventor: HIDAKA, Tetsuya, Yokohama-shi, Kanagawa 227-0067 (JP); KANEKO, Yawara, Kanagawa 253-0056 (JP)
(74) Representative: Schoppe, Fritz
(86) International application number: PCT/US2000/003265
(87) International publication number: WO 2000/049464

(56) References cited:
- EP-A- 0 342 061
- EP-A- 0 740 376
- EP-A- 0 921 577
- WO-A-98/49708
- DE-A- 2 534 158
- DE-A- 19 651 590
- JP-A- 10 321 912
- US-A- 5 200 300
- US-A- 5 420 048
- US-A- 5 637 519
- US-A- 5 679 498
- US-A- 5 976 902
- "Method for Fabricating Self-Aligned Thin-Film Transistors" IBM TECHNICAL DISCOSURE BULLETIN, vol. 41, no. 1, January 1998 (1998-01), pages 339-340, XP000772130

## Description

### Field of the Invention

The present invention relates to the fabrication of semiconductor devices, and more particularly, to a photolithography method and apparatus for manufacturing a device by using part of the formed device as a mask and exposing a photoresist with light that passes through the other portion of the device.

### Background of the Invention

The present invention can be more easily understood with reference to the fabrication of insulating layers; however, it will be obvious to those skilled in the art from the following discussion that the invention may be utilized in a wide variety of processes. Semiconductor fabrication often requires the formation of an insulating layer structure aligned with the surface of semiconductor devices having microstructures on the order of *µ*m. For example, Yoshinori Kimura, *et al.* have disclosed a method for forming a semiconductor laser device using a GaN-based material (*Jpn. J. Appl. Phys.,* Vol. 37 (1998), pp. L1231-L1233) in which a narrow optical waveguide with a width of 5 µm or less must be fabricated. A photoresist that has been patterned to a width of about 5 µm, or an etching mask material that has been patterned using this photoresist, is used as an etching mask. The underlying GaN-based material having the base pattern is etched to form a multi-mesa structure. With a device such as this, the area around the optical waveguide must be covered with an insulating material to insulate the portion around the optical waveguide from the electrode pad provided on top of this insulating material.

A number of prior art methods have been used to form such a structure. For example, a photoresist pattern can be photolithographically formed over the optical waveguide, the pattern being adjusted such that it is smaller than the optical waveguide. SiO₂ or the like is then vapor-deposited over the entire surface, and then an organic solvent, a photoresist exfoliant, or the like is used to remove the SiO₂ on the photoresist along with the photoresist in the regions of the underlying pattern that must exposed to make electrical contacts.

Alternatively, when the base pattern is formed, a second layer composed of another material is simultaneous patterned. These layers are then used as etching mask materials and the underlying GaN-based material is etched. An insulating film such as SiO₂ is then vapor-deposited, and the second layer and overlying insulating film are removed together to form an insulating film pattern. For example, in GaN systems, the GaN-based material is etched by reactive ion etching with the photoresist used during the formation of the base pattern still intact. Then lift-off patterning of the SiO₂ or other insulating film is performed using this photoresist as a lift-off material.

In the above-described methods, the photomask and the pattern formed first on the sample have to be properly aligned by a process that substantially increases the cost of fabrication. The alignment is typically checked manually using alignment marks on the sample and alignment marks on the photomask. An XY and rotary stage is then used to align the relative positions of the photomask and the sample until any misalignment is within tolerance. However, because an alignment margin of about 1 µm is required, these methods can only be applied to a photomask that is about 1 to 2 µm smaller than the base pattern.

The alignment may also be performed using an electron beam lithography system or a photo-stepper having a high-precision, automatic positioning system. However, the high cost of this equipment significantly increases the manufacturing cost.

To avoid the alignment costs, a SiO₂ or other insulating film is vapor-deposited over the entire surface of a sample, and the insulating film is removed from just the desired area by photolithography and etching technology. For example, in the etching of the GaN-based material, the photoresist serving as the mask material on top thereof is also etched. Unfortunately, the resultant pattern is rounded off, particularly at the edges. In addition, the reaction products produced during the etching make it more difficult for the photoresist to be peeled away. The shape changes in the photoresist and the formation of reaction products lead to diminished yields, which, in turn, increase the cost of manufacture. While this method does not require an accurate mask-alignment step, it does require the selective removal of the SiO₂ or other insulating film formed on the sample surface along with the photoresist after the etching of the GaN-based material.

Broadly, it is the object of the present invention to provide an improved fabrication method for providing a patterned insulating layer over an underlying semiconductor device or the like.

It is a further object of the present invention to provide a fabrication method that does not require a high-precision alignment operation.

It is a still further object of the present invention to provide a fabrication method that does not require costly alignment equipment.

These and other objects of the present invention will become apparent to those skilled in the art from the following detailed description of the invention and the accompanying drawings.

### Summary of the Invention

The present invention as defined in claim 1 is a method for generating a photoresist pattern on top of an object that includes a layer of material that is opaque to light of a predetermined wavelength. The object is first covered with a layer of photoresist material. The layer of photoresist material is then irradiated with light of the predetermined wavelength from a position under the object such that the object casts a shadow into the layer of photoresist. The photoresist material is then developed to generate the photoresist pattern. The step of irradiating the layer of photoresist material from below the object is accomplished by providing a reflecting surface below the object and a light source above the object. In such embodiments, a mask is positioned between the object and the light source such that the mask casts a shadow that covers the object and a portion of the area surrounding the object. The method of the present invention as defined in claim 3 is well suited for depositing a layer of dielectric material over a device in which the dielectric layer has a via therethrough terminating on a metallic pad that is part of the device.

### Brief Description of the Drawings

Figure 1 is a cross-sectional view of a partially fabricated laser diode in which the various layers that make up the final laser have been deposited and etched back to form a mesa structure.
Figure 2 is a cross-sectional view of the laser diode shown in Figure 1 after the photoresist layer of the present invention has been patterned.
Figure 3 is a cross-sectional view of the laser diode shown in Figures 1 and 2 after the deposition of the dielectric layer.
Figure 4 is a cross-sectional view of the a partially fabricated laser diode illustrating the manner in which a light source above the substrate can be utilized in the present invention.

### Detailed Description of the Invention

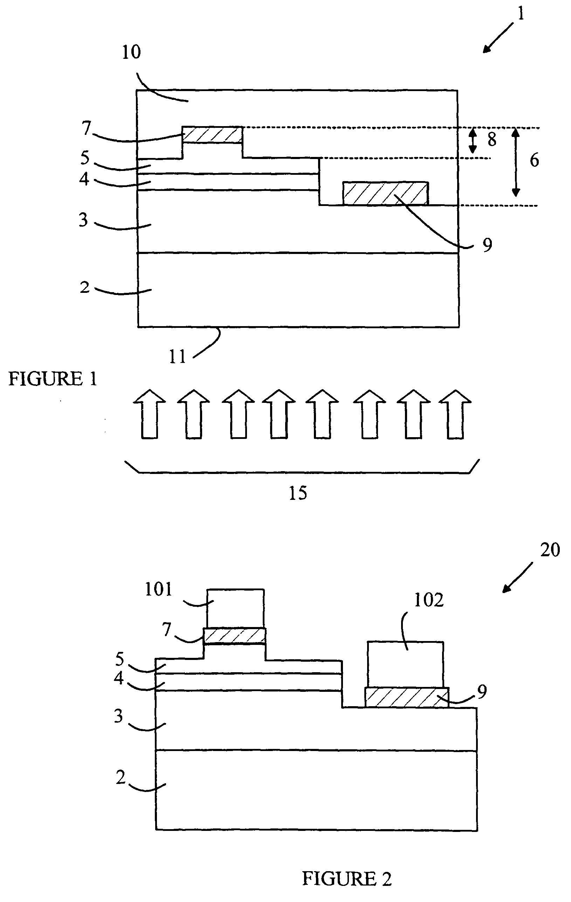

The manner in which the present invention achieves its advantages may be more easily understood with reference to an exemplary application of the method of the present invention to the fabrication of an edge emitting laser diode. Refer now to Figure 1, which is a cross-sectional view of a partially fabricated laser diode 1 in which the various layers that make up the final laser have been deposited and etched back to form a mesa structure. As shown in Figure 1, the device includes an n-GaN layer 3, a multi-quantum well (MQW) layer 4, and a p-GaN layer 5 grown in that order on a sapphire substrate 2 by conventional vapor deposition process such as MOCVD. The layered stack was then converted to a mesa structure 6 by etching these layers to a depth part-way through the n-GaN layer 3, thereby forming a mesa structure 6. The mesa structure 6 typically has a width of 100 µm and a height of approximately 1.4 µm.

Next, the metallic electrodes through which power will be provided to the finished device are deposited. A nickel thin film 7 with a thickness of 50 nm is deposited on the p-GaN layer by vacuum vapor deposition. The nickel thin film 7 is then patterned by photolithography and etching to form a pattern with a width of 1 to 100 µm. This patterned nickel thin film 7 is used as an etching mask to etch the p-GaN by reactive ion etching and to provide a protrusion 8 with a height of 400 nm on the top of the mesa structure 6. Then, a thin film 9 of aluminum in a thickness of 200 nm is formed by a lift-off method on the exposed portion of n-GaN next to the bottom of the mesa structure 6.

This dielectric layer prevents short circuits to the electrodes during the deposition of the metal layer used to connect the device to other circuitry. In this step, the entire top surface of the above-mentioned structure is coated by spin coating with a photoresist such as AZ6124 made by Hoechst, to form a photoresist layer 10 with a thickness of 2.5 µm. The photoresist layer is then patterned utilizing a light source 15 that exposes photoresist layer 10 from the underside of substrate 2 such that the thin films 7 and 9 act as exposure masks. An ultraviolet exposure of 20 seconds at an energy density of 1.5 mW per square centimeter is sufficient to expose the photoresist layer discussed above provided the wavelength is chosen such that the substrate is transparent at that wavelength.. After irradiation, the device is immersed for 40 seconds in a developer (such as an AZ developer made by Hoechst that has been diluted 1:1 with deionized water) to remove that portion of the resist which had been irradiated with the ultraviolet light. A cross-sectional view of the resulting structure 20 having photoresist patterns 101 and 102 is shown in Figure 2.

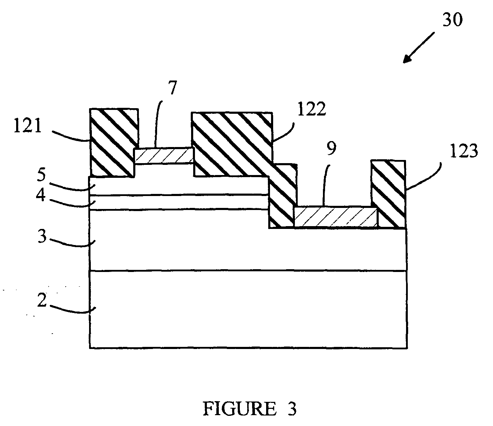

Refer now to Figure 3, which is a cross-sectional view of the device after the deposition of the dielectric layer. A SiO₂ film 12 is then vapor-deposited on top of structure 20. The SiO₂ over the photoresist patterns 101 and 102 is then removed by a conventional lift-off method to form SiO₂ films 121, 122, and 123, while leaving thin films 7 and 9 free for subsequent metal deposition which yields the device structure 30 shown in Figure 3.

The shape of the photoresist pattern generated in the above-described procedure has been measured with a scanning electron microscope. The results indicated that the photoresist pattern had more or less the same shape as that of the underlying metal films. The difference in size between the formed photoresist and the underlying nickel thin film was about 0.2 to 0.3 µm when the method discussed above was utilized. Hence, the method of the present invention can be used to form a photoresist pattern even on a base pattern with a width of 0.5 to 1 *µ*m.

The above-described embodiment of the present invention utilized aluminum and nickel as the base pattern. However, it will be obvious to those skilled in the art from the preceding discussion that any material that blocks light can be utilized. For example, tungsten, titanium, platinum, palladium, tantalum, chromium, silver, gold, aluminum, or another light-blocking material could be utilized in place of nickel or aluminum.

The embodiment of the present invention described above utilized an arrangement in which the light source used to expose the photoresist was placed under the substrate on which the laser was being fabricated. However, arrangements in which the light source is placed above the substrate may also be utilized. Such arrangements allow the substrate to be mounted to an opaque carriage such as those used in a conventional photolithographic apparatus.

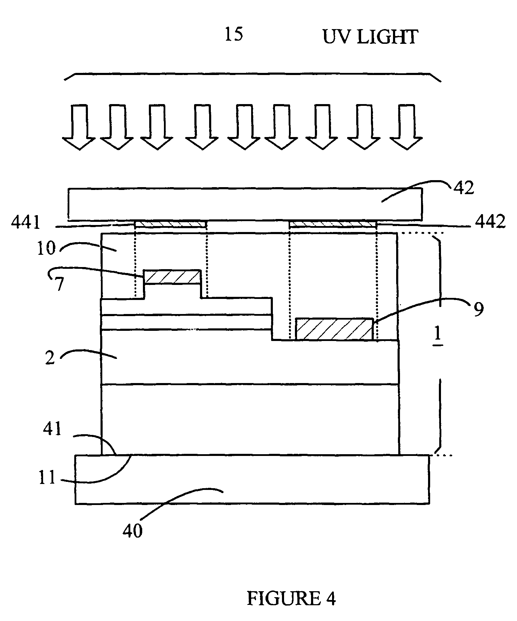

Refer now to Figure 4, which illustrates the manner in which the present invention can be practiced with a light source above the substrate. Figure 4 is a cross-sectional view of the substrate and layers at the same stage of the fabrication process as shown in Figure 1. The device structure shown in Figure 1 is placed on a table 40 having a surface 41 that reflects the exposure light. For example, table 40 may be a stainless steel sample table that is part of a conventional ultraviolet exposure apparatus. A photomask 42 having a mask pattern having opaque areas 441 and 442 is positioned over the photoresist layer 10 so as to cast a shadow over films 7 and 9. This mask blocks light from light source 15 that would otherwise directly expose the top surface of photoresist layer 10 in the region of films 7 and 9. The projection of the mask patterns 441 and 442 in the emission direction of the exposure light cover the thin films 7 and 9 as depicted by the broken lines in Figure 4.

The photoresist layer 10 can be patterned in approximately the same shape as the base pattern defined by films 7 and 9 by using the mask patterns 441 and 442, which extend out from the edges of the thin films 7 and 9 about 10 *µ*m. The exposure requires only a positioning precision of about 5 µm, since the exposure light will be reflected into the region under the mask patterns 441 and 442 except the region on thin film 7 and 9. An alignment precision of 5 µm can be easily attained merely by using a simple XY and rotary stage and a microscope. Hence, this embodiment of the present invention can be practiced on a conventional UV exposure apparatus without requiring high precision alignment.

With this method, any portion of the photoresist 10 on the base pattern can be covered by using a suitable photomask pattern. Hence, areas that are not to include the developed photoresist pattern and are not over a corresponding thin film mask can also be protected.

Even if the table 40 has no reflective surface, this method can be implemented with ease if the rear surface of the sample is coated with a material that reflects light, such as nickel, tungsten, titanium, platinum, palladium, tantalum, chromium, silver, gold, or aluminum. In addition, the amount of exposure light that sneaks into the base pattern can be modified by adjusting the distance between the reflective surface 41 and the base pattern films. The exposure can be fine-tuned through by altering the distance between the light source and the device structure and by altering the direction, polarization, and focusing of the light.

The above-described embodiments of the present invention have been discussed in reference to the construction of a laser diode. However, it will be appreciated from the preceding discussion that the present invention can be used to generate a photoresist pattern over any opaque structure without requiring that a mask be positioned over that structure to a high precision.

Various modifications to the present invention will become apparent to those skilled in the art from the foregoing description and accompanying drawings. Accordingly, the present invention is to be limited solely by the scope of the following claims.

## Claims

1. A method for generating a photoresist pattern (101, 102) on top of an object (7, 9) comprising a layer of material that is opaque to light of a predetermined wavelength, said method comprising the steps of:
covering said object (7, 9) with a layer of photoresist material (10);
irradiating said layer of photoresist material (10) with light of said predetermined wavelength from a position under said object (7, 9) such that said object (7, 9) casts a shadow into said layer of photoresist material (10) by providing a reflecting surface (41) below said object (7, 9), providing a light source (15) above said object (7,9), and providing a mask (42) between said object (7, 9) and said light source, said mask (42) casting a shadow that covers said object (7, 9) and a portion of the area surrounding said object (7, 9); and
developing said photoresist material to generate said photoresist pattern (101, 102).

2. The method of Claim 1 wherein said object is located on a transparent substrate and said reflective surface comprises a surface on a table on which the substrate is mounted.

3. A method for depositing a layer of dielectric material (121-123) over a device, said dielectric layer having a via therethrough terminating on a metallic pad (7, 9) that is part of said device, said method comprising:
performing a method according to claim 1, wherein said object is formed by said metallic pad, wherein said step of covering said object with a layer of photoresist material (10) comprises covering said device with a layer of photoresist material (10), and said step of developing said photoresist material (10) comprises removing those portions of said layer of photoresist material (10) that were exposed to light, thereby leaving a patterned layer of photoresist (101, 102) over said metallic pad (7, 9);
said method further comprising:
depositing a layer of said dielectric material over said device; and
removing said patterned layer of photoresist (101, 102).

4. The method of Claim 3 wherein said device comprises aplurality of layers of GaN deposited on a transparent substrate.

5. The method of Claim 4 wherein said substrate is sapphire.

## Patentansprüche

1. Ein Verfahren zum Erzeugen einer Photoresiststruktur (101, 102) auf einem Objekt (7, 9), das eine Schicht aus einem Material aufweist, das undurchlässig für Licht einer vorbestimmten Wellenlänge ist, wobei das Verfahren folgende Schritte aufweist:
Bedecken des Objekts (7, 9) mit einer Schicht aus einem Photoresistmaterial (10);
Bestrahlen der Schicht aus dem Photoresistmaterial (10) mit Licht der vorbestimmten Wellenlänge aus einer Position unter dem Objekt (7, 9), derart, dass das Objekt (7, 9) einen Schatten in die Schicht des Photoresistmaterials (10) wirft, indem eine reflektierende Oberfläche (41) unter dem Objekt (7, 9) bereitgestellt wird, indem eine Lichtquelle (15) über dem Objekt (7, 9) bereitgestellt wird, und indem eine Maske (42) zwischen dem Objekt (7, 9) und der Lichtquelle bereitgestellt wird, wobei die Maske (42) einen Schatten wirft, der das Objekt (7, 9) und einen Abschnitt des Bereichs, der das Objekt (7, 9) umgibt, bedeckt; und
Entwickeln des Photoresistmaterials, um die Photoresiststruktur (101, 102) zu erzeugen.

2. Das Verfahren gemäß Anspruch 1, bei dem das Objekt auf einem transparenten Substrat angeordnet ist und die reflektierende Oberfläche eine Oberfläche auf einem Tisch aufweist, auf dem das Substrat befestigt ist.

3. Ein Verfahren zum Aufbringen einer Schicht aus einem dielektrischen Material (121-123) über einer Vorrichtung, wobei die dielektrische Schicht ein Durchgangsloch durch dieselbe aufweist, das auf einer Metallanschlussfläche (7, 9) abschließt, die Teil der Vorrichtung ist, wobei das Verfahren folgenden Schritt aufweist:
Durchführen eines Verfahrens gemäß Anspruch 1, wobei das Objekt durch die Metallanschlussfläche gebildet wird, wobei der Schritt des Bedeckens des Objekts mit einer Schicht aus einem Photoresistmaterial (10) ein Bedecken der Vorrichtung mit einer Schicht aus einem Photoresistmaterial (10) aufweist und der Schritt des Entwickelns des Photoresistmaterials (10) ein Entfernen der Abschnitte der Schicht aus dem Photoresistmaterial (10), die belichtet wurden, aufweist, wodurch eine strukturierte Schicht des Photoresists (101, 102) über der Metallanschlussfläche (7, 9) verbleibt;
wobei das Verfahren ferner folgende Schritte aufweist:
Aufbringen einer Schicht des dielektrischen Materials über der Vorrichtung; und
Entfernen der strukturierten Schicht des Photoresists (101, 102).

4. Das Verfahren gemäß Anspruch 3, bei dem die Vorrichtung eine Mehrzahl von Schichten aus GaN, die auf einem transparenten Substrat aufgebracht werden, aufweist.

5. Das Verfahren gemäß Anspruch 4, bei dem das Substrat Saphir ist.

## Revendications

1. Procédé pour générer un motif de résine photosensible (101, 102) sur un objet (7, 9) comprenant une couche de matériau qui est opaque à la lumière d'une longueur d'onde prédéterminée, ledit procédé comprenant les étapes consistant à :
recouvrir ledit objet (7, 9) d'une couche de matériau de résine photosensible (10) ;
irradier ladite couche de matériau de résine photosensible (10) par de la lumière de ladite longueur d'onde prédéterminée depuis une position au-dessous dudit objet (7, 9), de sorte que ledit objet (7, 9) jette une ombre dans ladite couche de matériau de résine photosensible (10) en prévoyant une surface réfléchissante (41) au-dessous dudit objet (7, 9), en prévoyant une source de lumière (15) au-dessus dudit objet (7,9), et en prévoyant un masque (42) entre ledit objet (7, 9) et ladite source de lumière, ledit masque (42) jetant une ombre couvrant ledit objet (7, 9) et une partie de la zone entourant ledit objet (7, 9) ; et
révéler ledit matériau de résine photosensible pour générer ledit motif de résine photosensible (101, 102).

2. Procédé selon la revendication 1, dans lequel ledit objet est situé sur un substrat transparent et ladite surface réfléchissante comprend une surface sur un plateau sur lequel est monté le substrat.

3. Procédé pour déposer une couche de matériau diélectrique (121-123) sur un dispositif, ladite couche diélectrique présentant un orifice la traversant et se terminant sur un plot métallique (7, 9) faisant partie dudit dispositif, ledit procédé comprenant :
réaliser un procédé selon la revendication 1, dans lequel ledit objet est formé par ledit plot métallique, dans lequel ladite étape de recouvrement dudit objet d'une couche de matériau de résine photosensible (10) comprend le recouvrement dudit dispositif d'une couche de matériau de résine photosensible (10), et ladite étape de révélation dudit matériau de résine photosensible (10) comprend l'élimination des parties de ladite couche de matériau de résine photosensible (10) qui ont été exposées à la lumière, laissant ainsi une couche de résine photosensible à motifs (101, 102) sur ledit plot métallique (7, 9) ;
ledit procédé comprenant par ailleurs :
déposer une couche dudit matériau diélectrique sur ledit dispositif ; et
éliminer ladite couche de résine photosensible à motifs (101,102).

4. Procédé selon la revendication 3, dans lequel ledit dispositif comprend une pluralité de couches de GaN déposées sur un substrat transparent.

5. Procédé selon la revendication 4, dans lequel ledit substrat est du saphir.
